(19) Europäisches Patentamt
European Patent Office
Office européen des brevets

(11) **EP 3 292 559 B1**

(12) **EUROPEAN PATENT SPECIFICATION**

(45) Date of publication and mention of the grant of the patent:
**07.08.2019 Bulletin 2019/32**

(51) Int Cl.:
***H01J 37/32*** *(2006.01)* ***G01N 27/02*** *(2006.01)*

(21) Application number: **16721773.6**

(22) Date of filing: **03.05.2016**

(86) International application number:
**PCT/EP2016/059906**

(87) International publication number:
**WO 2016/177740 (10.11.2016 Gazette 2016/45)**

(54) **METHOD, MEASUREMENT PROBE AND MEASUREMENT SYSTEM FOR DETERMINING PLASMA CHARACTERISTICS**

VERFAHREN, MESSONDE UND MESVORRICHTUNG ZUR BESTIMMUNG VON PLASMAEIGENSCHAFTEN

MÉTHODE, SONDE DE MESURE ET APPAREIL DE MESURE POUR DÉTERMINER DES CHARACTÉRISTIQUES PLASMA

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.05.2015 EP 15166251**

(43) Date of publication of application:
**14.03.2018 Bulletin 2018/11**

(73) Proprietor: **Ecole Polytechnique Fédérale de Lausanne (EPFL)**
**1015 Lausanne (CH)**

(72) Inventors:
• **FURNO, Ivo**
  **1004 Lausanne (CH)**
• **HOWLING, Alan**
  **1053 Lausanne (CH)**
• **GUITTIENNE, Philippe**
  **1092 Belmont-Lausanne (CH)**

(74) Representative: **Banse & Steglich Patentanwälte PartmbB Patentanwaltskanzlei Herzog-Heinrich-Straße 23 80336 München (DE)**

(56) References cited:
**WO-A1-2010/092433**  **US-A- 4 458 202**
**US-A- 5 268 646**  **US-A1- 2012 084 046**

• A A Howling ET AL: "RF antennas as plasma monitors", , 24 May 2015 (2015-05-24), XP055290135, Retrieved from the Internet: URL:https://infoscience.epfl.ch/record/217 042/files/FLTPD_Howling_May2015.pdf [retrieved on 2016-07-20]
• HOWLING A A ET AL: "Complex image method for RF antenna-plasma inductive coupling calculation in planar geometry. Part I: basic concepts", PLASMA SOURCES SCIENCE AND TECHNOLOGY, INSTITUTE OF PHYSICS PUBLISHING, BRISTOL, GB, vol. 24, no. 6, 6 November 2015 (2015-11-06), page 65014, XP020292846, ISSN: 0963-0252, DOI: 10.1088/0963-0252/24/6/065014 [retrieved on 2015-11-06]

**Description**

Technical field

The present invention relates to the field of measuring plasma characteristics, particularly of measuring plasma conductivity.

Background of the related art

Plasma processes are widely used in many industrial fields, such as material etching and deposition in semiconductor industry for the manufacturing of flat-panel displays, photovoltaic solar cells and the like. To maintain the reliability of plasma processes, monitoring the plasma characteristics is of prime importance for successful plasma processing.

Various methods and devices for characterizing plasma properties are available in the art.

Popular devices for plasma characterization are Langmuir probes. The fundamental principle is to immerse a biased conductor in the plasma and to measure the collected current. By sweeping the biasing voltage, a current/voltage characteristic is obtained which can be interpreted to deduce essentially the ion saturation current, the electron temperature and the plasma potential. The electron density can then be deduced from the ion saturation current and the electron temperature. Measurements with Langmuir probes are difficult and the accuracy of measurement is poor. As the biased conductor is in direct contact with the plasma, the use of Langmuir probes can furthermore lead to contamination in some processes. In the very significant field of plasma deposition processes, the use of Langmuir probes is not possible as the biased conductor can become coated very rapidly with insulating layers.

Document US 5,936,413 A discloses a method for measuring the ion flow from a plasma to a probe. A radio frequency voltage is applied to a first terminal of a measuring capacitor connected between a radio frequency voltage source and a plate-shaped probe in contact with said plasma, whereby said capacitor is charged at a self-biasing potential of the plasma. The probe is periodically supplied with radio frequency oscillation trains and the discharge rate of the capacitor is measured between two oscillation trains. In contrast to the Langmuir probe, the ion flux probe can still function even when the surface is coated.

Document US 7,061,184 B2 discloses a technique of scanning a frequency band that is cut off when an electromagnetic wave corresponding to the natural frequency of plasma is applied to the plasma in order to use a correlation between the density and the natural frequency of plasma for measuring and monitoring the plasma density. Specifically, a device for measuring and monitoring the electron density of plasma is described that includes a frequency probe having an antenna structure with a pair of antennas for emitting a signal in one part of the plasma region and receiving the signal, respectively.

As e. g. known from documents US 7,878,045 B2, US 2005/009347 A1, and US 2013/160523 A1, probes are applied to utilize the phenomenon of plasma resonance at or near the electron plasma frequency. In contrast to cut-off probes, these probes use a one-port arrangement where a network analyzer measures the reflection coefficient as the probe frequency crosses the electron plasma frequency.

As known from US 6,573,731 B1, the electron density can further be measured by the interferometry method, for which the diagnostic frequency is greater than the cut-off frequency so that the radiation can propagate in the plasma. In this case an EM wave is launched through the plasma and is subsequently mixed with a reference signal. The resulting phase shift between the two signals depends on the line-averaged plasma density and on the chord length of the sampled plasma slab.

As disclosed in US 6,861,844 B1, the microwave cavity technique utilizes the fact that the cavity's resonance frequency depends on the permittivity of the medium inside the cavity for measuring the electron density. A plasma-caused frequency shift is related to the free electron density. Typically, the plasma reactor is designed as a cylindrical cavity with a single resonant mode.

According to JP 2010 232110 A, another technique of extracting the plasma density is also based on measuring the cold-plasma permittivity. A resonant structure is directly inserted into the plasma and the shift in the resonance frequency is measured, which depends on the plasma dielectric constant.

Document US 2012/084046 A1 discloses an L-C resonant probe, comprising an inductor and a capacitor in series. The plasma frequency is estimated by measuring the change of the series resonance frequency when the capacitor element is immersed in the plasma. This effect is based on the relative permittivity of the plasma changing the value of the capacitance.

Alternatively, as shown in US 5,471,115 A, an electron beam can be injected to generate a plasma oscillation at the plasma frequency, which can be detected by an antenna and a frequency analyzer.

As shown from US 4,458,202 A1 a device for measuring local electric conductivity of plasma may comprise a probe having a casing and a working end, an inductive sensor provided at said working end of the probe, a drive mechanism of said probe which is kinematically coupled to the probe, a measuring oscillator accommodated in said casing of said probe, and a detector having an input and an output. It is disclosed that the probe is arranged to enter a low-temperature plasma to measure its electric conductivity. The inductive sensor, i.e. a coil is combined to capacitors and thereby forms a resonant oscillator circuit.

US 2012/084046 A1 discloses an L-C resonant probe, which comprises an inductor and a capacitor in series. The plasma frequency is estimated by measuring the change of the series resonance frequency when the capacitor element is immersed into the plasma. By comparing the resonance frequencies in the presence and in the absence of a plasma, the electron density may be determined.

US 5,268,646 A1 discloses an apparatus for determining the conductivity of a superconducting material without making electrical contact therewith. The material is located adjacent to one or more inductors that form part of a resonant LC circuit; changes in self-inductance (or mutual inductance when more than one inductor is involved) are linked to changes in conductivity of the material, and are measured as a function of the material's temperature.

WO 2010/092433 A1 discloses an apparatus for plasma processing comprising a plane antenna, a radiofrequency generator exciting said antenna, a gas injection system and diffuser, a process chamber in a proximity to the antenna, wherein the plane antenna comprises a plurality of interconnected elementary resonant meshes, each mesh comprising at least two conductive legs and at least two capacitors, so that the antenna has a plurality of resonant frequencies, and wherein said radiofrequency generator excites said antenna to at least one of its resonant frequencies.

It is an object of the present invention to provide an improved method for determining plasma parameters such as the electron density and the electron-neutral collision frequency.

Summary of the invention

This object has been achieved by the method for determining a plasma complex conductivity according to claim 1 as well as by the measurement probe and the measurement system according to the further independent claims.

Further embodiments are indicated in the dependent subclaims.

According to a first aspect, a method for determining plasma characteristics is provided, comprising the steps of:

- arranging a measurement probe having a self-inductance in proximity to a plasma to establish inductive coupling between the plasma and the measurement probe;
- determining a mutual inductance between the measurement probe and the plasma;
- depending on the mutual inductance, estimating a quantity representing the plasma complex conductivity; and
- deriving at least one plasma parameter from the quantity representing the plasma conductivity.

One idea of the above measurement method is to determine at least one plasma parameter based on a quantity representing the plasma complex conductivity. The quantity corresponds to a representation of a plasma complex conductivity as a parameter or a function. The quantity representing the plasma electrical conductivity is determined based on a mutual inductance between a measurement probe and the plasma. The mutual inductance results from currents induced in the plasma which are inductively coupled to the current in the probe. The inductive coupling affects the impedance of the measurement probe in proximity of the plasma.

According to one embodiment, the plasma-to-probe mutual inductance is, to a good approximation, equivalent to the mutual inductance between the measurement probe and its image with regard to a mirror plane located at a complex distance below the plasma surface. For an appropriate choice of probe geometry, the mutual inductance can then be easily calculated.

Furthermore, at least one plasma parameter may include an electron density and an electron-neutral collision frequency.

Moreover, the quantity representing the plasma complex conductivity (representation of plasma complex conductivity) may correspond to one of the plasma complex conductivity, a plasma complex resistivity or a complex distance (p), wherein the complex distance (p) is defined as a distance of a mirror plane of a mirrored image of the probe (2), wherein the mirror plane is located at the complex distance below the plasma surface (PS) which results in the determined mutual inductance.

According to one embodiment, the mutual inductance may be determined by a mutual inductance between the measurement probe and its image with regard to a mirror plane, wherein the mirror plane is located at a complex distance below the plasma surface.

According to an embodiment the mutual inductance may be determined by determining a change of inductivity of the measurement probe before and after the measurement probe has been arranged in proximity to the plasma. The method for determining plasma parameters is hence based on the measurement of the impedance of the measurement probe inductively coupled to the plasma. The effect on the impedance due to the coupling to the plasma may be interpreted in terms of plasma complex conductivity.

It may be provided that at least one plasma parameter is derived from the imaginary and real parts of the electrical plasma complex conductivity, both of which depend on the plasma parameters.

Moreover, the mutual inductance may be determined by determining a resonance frequency of a resonant circuit including the measurement probe, wherein a probe temperature of the measurement probe is determined, wherein the determined resonance frequency is corrected based on the determined probe temperature.

Alternatively, the temperature of the measurement probe may be kept constant during the time of measurement.

According to a further aspect, a measurement probe for determining plasma characteristics is provided, comprising:

- an inductive measurement probe; and
- a parallel or series capacitive component to form a resonant circuit.

Furthermore, the measurement probe may comprise a plurality of inductive elements arranged in a network. This network can incorporate any number of series or parallel capacitors to exhibit resonant behavior properties.

The capacitors may have a temperature coefficient of their capacity, which is sufficiently low for the required precision of the probe measurement, or wherein the capacitors have a controlled temperature.

According to an embodiment, the measurement probe may comprise a plurality of probe legs each including a line inductance in series with a leg capacitor, wherein the plurality of probe legs is coupled with stringer capacitors of a ladder network, wherein the series resonant frequency of the probe legs substantially corresponds to the parallel resonant frequency determined by the stringer capacitors.

According to a further aspect, a measurement system is provided, comprising:

- the above measurement probe arranged in a proximity to a plasma to establish inductive coupling; and
- a control unit for determining plasma characteristics, wherein the control unit is configured to determine a mutual inductance between the measurement probe and the plasma; to estimate a quantity representing the plasma complex conductivity depending on the mutual inductance; and to derive at least one plasma parameter from the quantity representing the plasma complex conductivity.

Moreover, the measurement probe may be coupled with a temperature control system configured to keep the temperature of the measurement probe constant during time of measurement.

Brief description of the drawings

Embodiments are described in more detail in conjunction with the accompanying drawings in which:

Figure 1     schematically shows a measurement arrangement of a measurement probe in the proximity of a plasma;

Figure 2     shows a flowchart for describing a method for determining plasma parameters;

Figure 3     schematically shows a model for a measurement arrangement of a measurement probe in the proximity of a plasma which is mirrored about a mirroring plane at complex distance;

Figure 4     shows an example of a measurement arrangement with a coil as a measurement probe which is a part of a resonant circuit.

Figure 5     schematically shows an example measurement probe formed as a hybrid resonant network antenna;

Figure 6     shows a characteristic of a measured variation of the resonant frequency of a measurement probe forming a hybrid resonant network as a function of RF power injected into a plasma source;

Figure 7     shows a computed relation between the electron density and the network resonant frequency change;

Figure 8     shows an electron density as a function of the source injected power;

Figure 9     shows a computed relation between the electron density and a network resonant frequency for a high pass antenna with, and without, accounting for parasitic capacitive coupling between the measurement probe and the plasma; and

Figure 10    shows a computed relation between the electron density and the network resonant frequency for the measurement probe of figure 5 when the parasitic capacitive coupling effect was minimized by appropriate choice of $C_s$.

Description of embodiments

The following description relates to a method for measuring the electrical conductivity of a plasma for deriving plasma characteristics, such as electron density and electron-neutral collision frequency. The electrical conductivity of the plasma shall be derived from a mutual inductance between the plasma and the measurement probe.

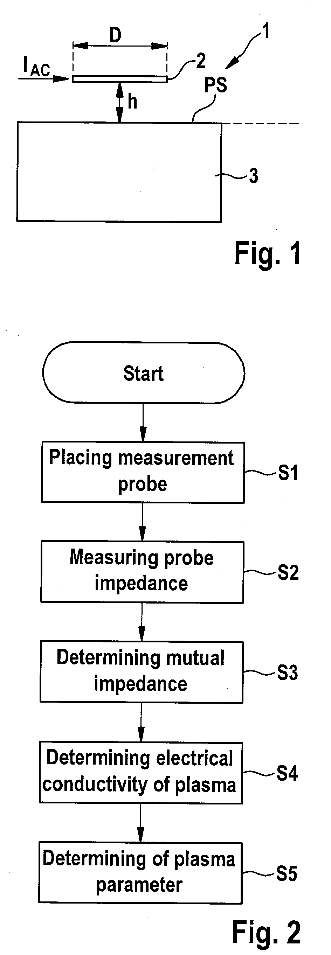

Figure 1 generally shows a measurement system 1 in which a measurement probe 2 having a self-inductance L is placed in proximity to a plasma surface PS of a plasma 3. The measurement probe 2 may be designed as a straight wire or as any kind of element having a specific self-inductance L.

The distance h between the plasma surface PS and the measurement probe 2 is such that a mutual induction with the measurement probe 2 occurs and induces current to flow in the plasma 3 due to its non-negligible electrical conductivity σ.

Given a fixed distance of the measurement probe 2, the mutual induction strongly depends on the characteristics of the plasma 3. It has been found that plasma parameters such as the electron density $n_e$ and the electron-neutral collision frequency $v_m$ may be derived therefrom.

The mutual inductance $M_{probe/plasma}$ between the measurement probe 2 and the plasma surface PS results in that the probe impedance $Z_{probe}$ at the frequency $f = \dfrac{\omega}{2\pi}$ is modified, as follows:

$$Z_{probe} = R + i\omega\left(L - M_{probe/plasma}\right),$$

wherein R represents the resistance of the measurement probe 2 which substantially corresponds to the real part of the vacuum impedance.

As is clear from the above equation, the probe impedance $Z_{probe}$ varies depending on a mutual inductance coupling with the plasma 3.

To determine the variation of the probe impedance $Z_{probe}$ in terms of the plasma parameters of the plasma 3, the mutual inductance $M_{probe/plasma}$ is to be determined. The mutual inductance $M_{probe/plasma}$ represents a measure of a mutual inductive coupling between the measurement probe 2 and the distribution of current it induces in the plasma 3 (with a non-negligible electrical conductivity σ).

The method for determining plasma parameters is described with respect to the flowchart of Figure 2.

In step S1, the measurement probe 2 of known resistance R and self-inductivity L is brought into proximity to the plasma surface PS so that the distance between the measurement probe 2 and the plasma surface PS equals the distance h. Substantially, the measurement probe 2 has one or two length dimensions which are preferably brought into a parallel arrangement to the plasma surface PS.

In step S2, the probe impedance $Z_{probe}$ of the measurement probe 2 being in proximity to the plasma surface PS is determined. The probe impedance $Z_{probe}$ can be determined by a number of methods some examples of which are described below.

In step S3, the mutual inductance $M_{probe/plasma}$ can be determined by the equation given above, as the self-inductance L and the resistance R of the measurement probe 2 are known or otherwise determined before the measurement.

In step S4, the plasma complex conductivity σ may be estimated from the mutual inductance $M_{probe/plasma}$ according to the method described below. Alternatively, a plasma complex resistivity may be estimated.

In step 5, the plasma parameters are derived from the electrical conductivity σ of the plasma 3.

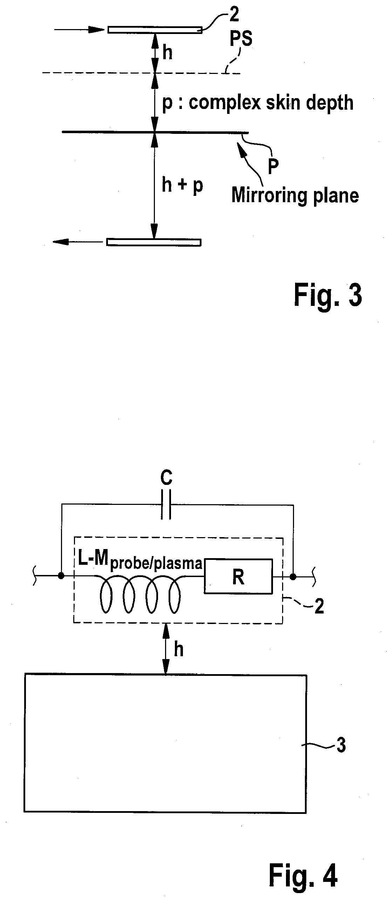

Due to the spatially distributed induced current in the plasma 3, the mutual inductance $M_{probe/plasma}$ between the measurement probe 2 and the plasma 3 can be regarded as equivalent to the mutual inductance between the measurement probe 2 and its mirror image with regard to a plane P located at a complex depth at a distance p below the plasma surface PS. This is illustrated in Figure 3, wherein the virtual image of the measurement probe 2 is located at a distance of 2 (h + p). The distance p is the complex skin depth for plane waves $H = H_0 \exp[i\omega t - z/p]$, wherein the complex skin depth p and the plasma electrical conductivity σ are related as follows:

$$\sigma = \frac{1}{i\omega\mu_0 p^2}$$

wherein $\mu_0$ is the permeability of free space.

Due to electron inertia, the electrical conductivity $\sigma$ of the plasma 3 is complex.

The complex electrical conductivity $\sigma_P$, the electron density $n_e$ and the effective electron neutral collision frequency $v_m$ can be related as follows:

$$\sigma_P = \frac{n_e q^2}{m_e(v_m + i\omega)},$$

where q is the electron charge and $m_e$ is the electron mass.

According to these assumptions, the calculation of the mutual inductance $M_{probe/plasma}$ between the measurement probe 2 and the plasma 3 can be reduced to a calculation of the mutual inductance $M_{probe/plasma}$ between the measurement probe 2 and its image with regard to a mirror plane located at a complex distance p below the plasma surface PS.

For calculating the mutual inductance $M_{probe/plasma}$ between the measurement probe 2 and its image, the geometry of the measurement probe 2 is essential. Provided that the geometry of the measurement probe 2 is properly chosen, analytical expressions for mutual inductances can be used. Notably, accurate expressions for the mutual inductance in the fundamental case of straight wires of any relative orientation can be found. Following this example, the mutual inductance $M_{probe/plasma}$ of two parallel wires of length D separated by a distance 2 (h + p) is approximately given as follows:

$$M_{probe/plasma} \approx \frac{\mu_0 D}{2\pi}\left[\ln\left(\frac{D}{h+p}\right)-1\right].$$

As an alternative method for estimating the mutual inductance $M_{probe/plasma}$ between the measurement probe 2 and the plasma 3, the arrangement can be regarded as a transformer, wherein the measurement probe 2 is considered to be the primary side of an air core transformer and the plasma 3 to be the secondary side of the transformer. However, the transformer method can only be used in cases of simple geometry (such as solenoids), and is not applicable to complicated arrangements such as resonant networks.

Based on the above formula, the measurement of the mutual inductance $M_{probe/plasma}$ can be directly interpreted to determine the complex skin depth p in step S4. As p is a complex distance, the mutual inductance $M_{probe/plasma}$ is also complex and both imaginary and real parts of the probe impedance $Z_{probe}$ will vary with the inductive coupling.

As imaginary and real parts of the plasma complex conductivity $\sigma_P$ can be deduced from this measurement, the electron density $n_e$, and the effective electron-neutral collision frequency $v_m$ can be determined as follows:

$$n_e = \frac{\omega m_e}{q^2 \text{Im}\left(\frac{1}{\sigma_P}\right)}$$

$$v_m = \omega \frac{\text{Re}\left(\frac{1}{\sigma_P}\right)}{\text{Im}\left(\frac{1}{\sigma_P}\right)}$$

Regarding the measurement of the complex probe impedance $Z_{probe}$ of the measuring element 2 in step S2, there are several approaches. According to a first approach, the probe impedance $Z_{probe}$ of the measuring element 2 is defined as the ratio V/I, with V being the voltage across the measuring element 2 and I the current flowing through it. For time-harmonic variation at a frequency $f = \frac{\omega}{2\pi}$, V and I are complex amplitudes so that the determination of the complex probe impedance $Z_{probe}$ at a frequency f requires the measurement of the voltage real amplitude |V| the current real amplitude |I| and the current/voltage temporal phase shift $\Phi$. For performing the measurements of these quantities, the measurement probe 2 can be generally included in a measurement bridge, such as a high frequency Wheatstone Bridge.

Furthermore, the measurement probe 2 can be included in a resonant circuit, an example of which is shown in Figure 4 and illustrates the simplest configuration of a parallel RLC circuit. According to the expression for the probe impedance $Z_{probe}$ of the measurement probe 2, the system 1 presents a resonance at the frequency:

$$f_r = \sqrt{\frac{L-Re[M_{probe/plasma}]-C(R+\omega Im[M_{probe/plasma}])^2}{C(L-Re[M_{probe/plasma}])^2}},$$

wherein the measurement of this resonant frequency allows for the mutual inductance $M_{probe/plasma}$ to be quantified.

One advantage of the method described above is that it allows to use complex structures for the measurement probe 2 as long as they can be decomposed into simple elementary components for which analytical expressions for the mutual inductance $M_{probe/plasma}$ are known. For example, networks composed with straight inductive elements can be used as measurement probe 2, wherein each element of the network is mutually coupled to the others as well as to all mirrored elements and their image currents. Therefore, all these mutual inductances $M_{probe/plasma}$ can be calculated analytically as they involve only straight elements, so that a calculation of a conventional matrix of the network can be performed. Networks of measurement probes 2 may not only incorporate inductive elements but also other types of elements, such as capacitors in order to obtain resonant networks.

Furthermore, the measurement probe 2 can be wall-mounted, such as behind a dielectric window or a wafer, or mounted on a stationary or moving measurement probe head in the plasma 3. The probe may include a conducting backing plate and/or various types of segmented Faraday screens between the measurement probe 2 and the plasma 3 to reduce capacitive coupling while maintaining inductive coupling.

The resonant network can be designed to have a high-pass, low-pass or hybrid design depending on the various placements of antenna capacitors. The antenna can be designed to operate at a desired frequency and with a desired mode structure for the current distribution in the antenna and the plasma 3.

The antenna can take various forms, such as planar/curved/cylindrical, it can be smaller than the relevant plasma surface PS, or it can surround the plasma 3 to conduct global measurements.

The antenna-like measurement probe 2 can be combined with a plasma source or measurements of a plasma source itself could be used for diagnostic purposes.

The network design of the measurement probe 2 can be formed with conducting bars or inductors or straight wires or printed circuits or conducting traces deposited on dielectrics, such as alumina, glass, quartz and the like, or any combinations thereof, including straight conductors in series with inductor components.

In the above network measurement probes, capacitors could be bulk capacitors or surface-mounted capacitors or capacitors of any physical design, such as parallel plates or overlapping conductors and the like.

The measurement of the probe impedance $Z_{probe}$ can include a change of impedance, a shift in frequency, such as a shift in resonance frequency, a change in resonance peak width and amplitude or any combination thereof.

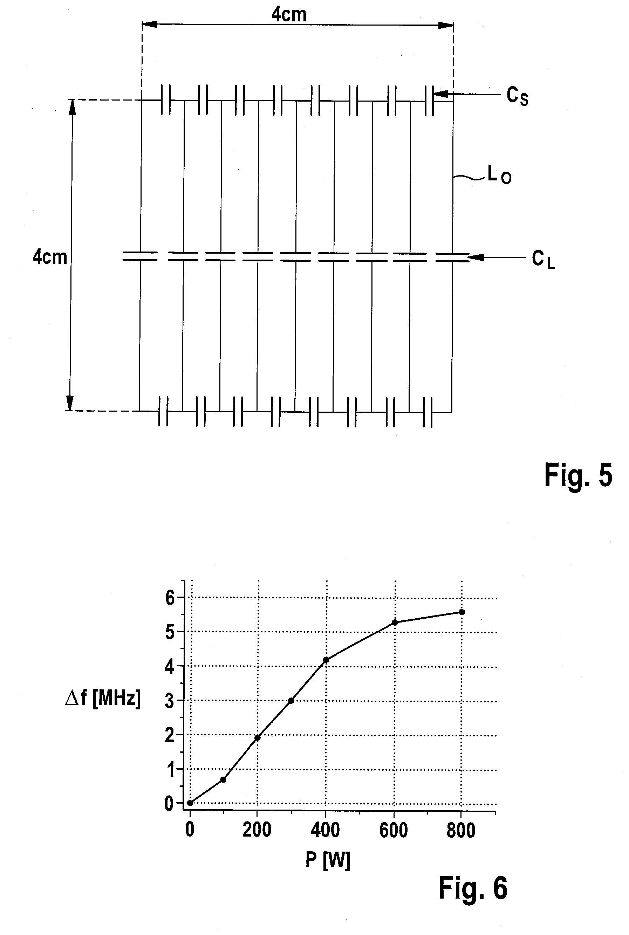

As an example, Figure 5 shows a schematic of a resonant network used as a measurement probe 2 for the results shown herein. The measurement probe 2 may have square dimensions, such as 4 cm x 4 cm, with 9 parallel legs. Each leg may incorporate a capacitor $C_L$ of e. g. 5.6 pF in series while each stringer incorporates a series capacitor $C_S$ of e. g. 47 pF. The measurement probe 2 may be placed at a distance of h = 0.8 cm above the plasma surface PS, so that the plane of the square shaped measurement probe 2 is in parallel to the plasma surface PS. The plasma may be generated by an RF inductive plasma source, whose impedance spectrum is measured by means of a network analyzer.

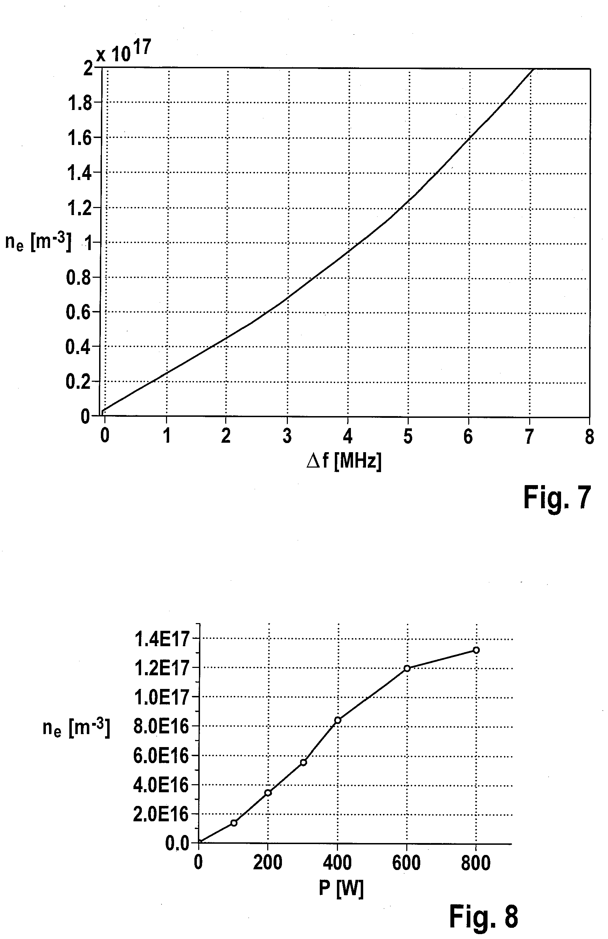

In absence of the plasma 3 the above measurement probe 2 presents a resonance at 370 MHz. The resonant frequency changes as the measurement probe 2 is brought into the proximity of the plasma 3, so that the resonant frequency change $\Delta f$ can be recorded as a function of the RF power P injected into the source. These characteristics of the variation of the resonant frequency over the RF power P is shown in Figure 6. The measured resonance frequency change $\Delta f$ may be interpreted in terms of plasma electron density $n_e$. So, Figure 7 shows a relation between the electron density and the resonant frequency change $\Delta f$ of the measurement probe 2 of Figure 5 computed as described above. Correspondingly, Figure 8 shows the electron density $n_e$ as a function of the source injected power P using the measurements of figure 5 and the calculated calibration curve of figure 7.

The measurement probe 2 in the above-described network design is coupled to the plasma 3 not only inductively but also capacitively. The effect of this combined coupling can be interpreted as a distributed capacitance between the measurement probe 2 and the electrical ground. These parasitic capacitances may be quite small because of the relatively large distance h between the plasma surface PS and the measurement probe 2, but can strongly affect the variation of the resonance frequency f of the measurement probe 2 with respect to the plasma electron density $n_e$, especially at higher frequencies.

In the network design of the measurement probe 2 as described above, a 4 cm leg represents a self-inductance $L_0$ of about 33.5 nH which is in series with the capacitance $C_L$. The resulting imaginary impedance for one leg is

$$Z_{leg} = i\omega L_0 - \frac{i}{\omega C_L},$$ which vanishes in the above example at a frequency of about 367 MHz. The value for the stringer capacitors of $C_S$ = 47 pF is then selected in order to make the network resonate close to its value of 367 MHz. By doing so, the impact of the capacitive coupling is minimized while the sensitivity for the mutual inductance $M_{probe/plasma}$ is maintained.

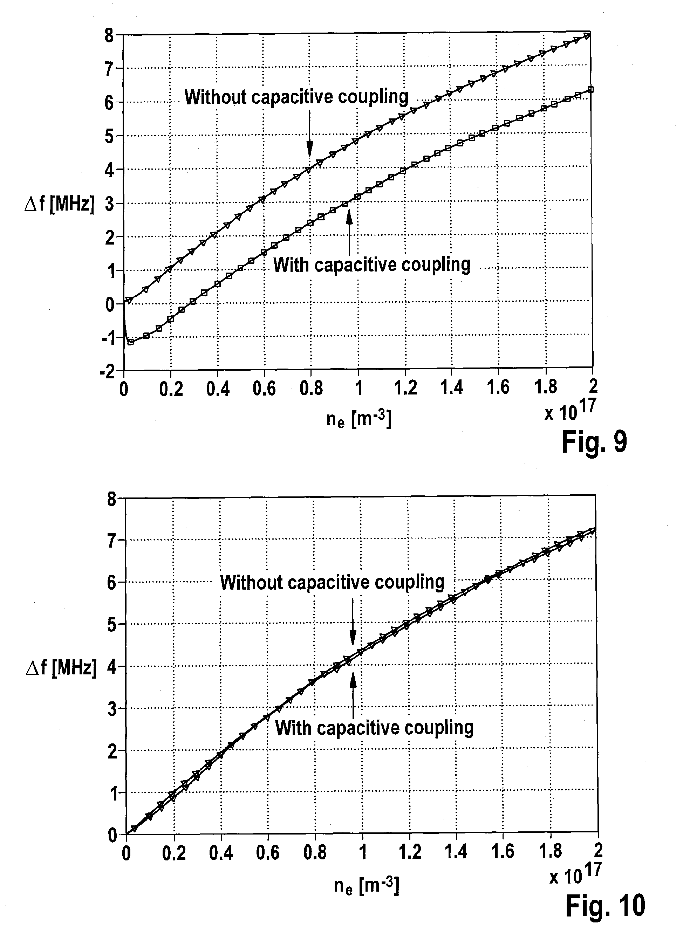

With respect to this, Figure 9 shows a computed relation between the electron density and the resulting resonant frequency change $\Delta f$ for a measurement device of Figure 5 with, and without, accounting for parasitic capacitive coupling between the network and the plasma. Figure 10 shows a computed relation between the electron density and the resonant frequency change $\Delta f$ for the measurement device of Figure 5 when the parasitic capacitive coupling effect was minimized by appropriate choice of $C_S$.

Due to the temperature dependency of the capacitance of the capacitors or the capacitive elements forming the resonant circuit or resonant network, respectively, together with the measurement probe, the resonant frequency will also experience a certain temperature dependency. This is particularly relevant as the measurement probe in contact with the plasma will heat up significantly so that a notable change of the resonant frequency can be observed.

To eliminate or reduce the temperature dependency on the measurement of the resonant frequency, the capacitors or the capacitive elements can be selected to have a low temperature coefficient regarding their capacity, so that the drift of the probe resonant frequency when the measurement probe 2 is heated by exposure to the plasma can be neglected with respect to the required precision of the measurement.

As an alternative approach during measurement of the resonant frequency the probe temperature, particularly the temperature of the capacitors or the capacitive element can be determined for example by a temperature-sensitive resistance element closely attached to the capacitors or the capacitive element, respective. According a correction function, e.g. using a look-up table, a correction value can be associated to the determined temperature. The correction value can be applied on the measured resonant frequency, e.g. by multiplication, to obtain a corrected (temperature compensated) resonant frequency. The corrected resonant frequency then may form the basis for determining the mutual inductance $M_{probe/plasma}$ as described above.

The temperature correction function can be e.g. obtained by measuring the resonance frequency of the antenna, for example using a network analyser, as a function of the temperature of the dielectric plate. A set of characteristic antenna parameters, such as the resonant frequency, can be computed for each temperature thus allowing to remove the effect of the thermal drift.

As an alternative, the temperature of the measurement probe can be controlled by a suitable heating (or cooling) system so that the measurement probe can be kept at constant temperature during time of measurement of resonant frequency.

Reference list

| 1 | measurement system |
| 2 | measurement probe |
| 3 | plasma |
| $C_L$, $C_s$ | capacitances |
| D | probe length |
| $\Delta f$ | resonant frequency variation |
| h | distance between plasma surface PS and measurement probe 2 |
| $I_{AC}$ | alternating current |
| L, $L_0$ | self-inductance |
| $M_{probe/plasma}$ | mutual inductance |
| $n_e$ | electron density |
| p | complex distance/skin depth |
| PS | plasma surface |

| R | resistance |
| σ | electrical conductivity |
| $\sigma_P$ | complex plasma conductivity |
| $v_m$ | electron neutral collision frequency |
| $Z_{probe}$ | probe impedance |
| P | mirroring plane |

**Claims**

1. Method for determining plasma characteristics, comprising the steps of:

   - arranging a measurement probe (2) having a self-inductance in proximity to a plasma (3) to establish inductive coupling between the plasma (3) and the measurement probe (2);
   - determining a mutual inductance ($M_{probe/plasma}$) between the measurement probe (2) and the plasma (3);
   - depending on the mutual inductance ($M_{probe/plasma}$), estimating a quantity representing the plasma complex conductivity (σ) ; and
   - deriving at least one plasma parameter from the quantity representing the plasma conductivity (σ).

2. Method according to claim 1, wherein at least one of the plasma parameters includes an electron density ($n_e$) and an electron-neutral collision frequency ($v_m$).

3. Method according to claim 1 or 2, wherein the quantity representing the plasma complex conductivity (σ) corresponds to the plasma complex conductivity (σ), a plasma complex resistivity or a complex distance (p), wherein the complex distance (p) is defined as a distance of a mirror plane of a mirrored image of the probe (2), wherein the mirror plane is located at the complex distance below the plasma surface (PS) which results in the determined mutual inductance.

4. Method according to any of the claims 1 to 3, wherein the mutual inductance ($M_{probe/plasma}$) is determined by the mutual inductance ($M_{probe/plasma}$) between the measurement probe (2) and its image with regard to a mirror plane, wherein the mirror plane is located at a complex distance (p) below the plasma surface (PS).

5. Method according to any of the claims 1 to 4, wherein the mutual inductance is determined by determining a change of inductivity of the measurement probe (2) before and after the measurement probe (2) has been arranged in proximity to the plasma (3).

6. Method according to any of the claims 1 to 5, wherein the quantity representing the plasma complex conductivity (σ) corresponds to the plasma complex conductivity (σ), wherein at least one plasma parameter is derived from the imaginary and real parts of the plasma complex conductivity (σ), both of which depend on the plasma parameters.

7. Method according to any of the claims 1 to 6, wherein the mutual inductance is determined by determining a resonance frequency of a resonant circuit including the measurement probe, wherein a probe temperature of the measurement probe (2) is determined, wherein the determined resonance frequency is corrected based on the determined probe temperature.

8. Method according to any of the claims 1 to 6, wherein the temperature of the measurement probe (2) is kept constant during the time of measurement.

9. Measurement probe (2) for determining plasma characteristics, comprising:

   - an inductive measurement probe (2); and
   - a parallel or series capacitive component to form a resonant circuit;
   - a plurality of probe legs each including a line inductance in series with a leg capacitor, wherein the plurality of probe legs are coupled with stringer capacitors of a ladder network, wherein the series resonant frequency of the probe legs substantially corresponds to the parallel resonant frequency determined by the stringer capacitors.

10. Measurement probe (2) according to claim 9, comprising a plurality of inductive elements arranged as a network.

11. Measurement probe (2) according to claim 9 or 10, including a number of capacitors.

**12.** Measurement probe (2) according to any of the claims 9 to 11, wherein the capacitors have a temperature coefficient of their capacity which is sufficiently low for the required precision of the probe measurement, or wherein the capacitors have a controlled temperature.

**13.** Measurement system (1) comprising:

- a measurement probe (2) for determining plasma characteristics, comprising an inductive measurement probe (2) and a parallel or series capacitive component to form a resonant circuit; wherein the measurement probe (2) is arranged in proximity to a plasma (3) to establish inductive coupling; and
- a control unit for determining plasma characteristics, wherein the control unit is configured to determine a mutual inductance ($M_{probe/plasma}$) between the measurement probe (2) and the plasma (3); to estimate a quantity representing the plasma complex conductivity ($\sigma$) depending on the mutual inductance ($M_{probe/plasma}$); and to derive at least one plasma parameter from the quantity representing the plasma complex conductivity ($\sigma$).

**14.** Measurement system (1) according to claim 13, wherein the measurement probe (2) is coupled with a temperature control system configured to keep the temperature of the measurement probe (2) constant during time of measurement.

**Patentansprüche**

**1.** Verfahren zum Bestimmen von Plasmaeigenschaften, umfassend die Schritte:

- Anordnen einer Messsonde (2) mit einer Eigeninduktivität in der Nähe eines Plasmas (3), um eine induktive Kopplung zwischen dem Plasma (3) und der Messsonde (2) herzustellen;
- Bestimmen einer gegenseitigen Induktivität ($M_{probe/plasma}$) zwischen der Messsonde (2) und dem Plasma (3);
- in Abhängigkeit von der gegenseitigen Induktivität ($M_{probe/plasma}$), Schätzen einer Größe, die die komplexe Leitfähigkeit des Plasmas ($\sigma$) darstellt; und
- Ableiten mindestens eines Plasmaparameters aus der Größe, die die Leitfähigkeit des Plasmas ($\sigma$) darstellt.

**2.** Verfahren nach Anspruch 1, wobei mindestens einer der Plasmaparameter eine Elektronendichte ($n_e$) und eine elektronenneutrale Kollisionsfrequenz ($v_m$) beinhaltet.

**3.** Verfahren nach Anspruch 1 oder 2, wobei die Größe, die die komplexe Leitfähigkeit des Plasmas ($\sigma$) darstellt, der Größe der Leitfähigkeit des Plasmas ($\sigma$), einem komplexen Widerstand des Plasmas oder einem komplexen Abstand (p) entspricht, wobei der komplexe Abstand (p) als Abstand einer Spiegelebene eines gespiegelten Bildes der Sonde (2) definiert ist, wobei die Spiegelebene in dem komplexen Abstand unterhalb der Plasmaoberfläche (PS) angeordnet ist, woraus sich die bestimmte gegenseitige Induktivität ergibt.

**4.** Verfahren nach einem der Ansprüche 1 bis 3, wobei die gegenseitige Induktivität ($M_{probe/plasma}$) durch die gegenseitige Induktivität ($M_{probe/plasma}$) zwischen der Messsonde (2) und ihrem Abbild in Bezug auf eine Spiegelebene bestimmt wird, wobei die Spiegelebene in einem komplexen Abstand (p) unterhalb der Plasmaoberfläche (PS) angeordnet ist.

**5.** Verfahren nach einem der Ansprüche 1 bis 4, wobei die gegenseitige Induktivität durch Bestimmen einer Änderung der Induktivität der Messsonde (2) bestimmt wird, bevor und nachdem die Messsonde (2) in der Nähe des Plasmas (3) angeordnet wurde.

**6.** Verfahren nach einem der Ansprüche 1 bis 5, wobei die Größe, die die komplexe Leitfähigkeit des Plasmas ($\sigma$) darstellt, der Größe der Leitfähigkeit des Plasmas ($\sigma$), entspricht, wobei mindestens ein Plasmaparameter aus dem imaginären und dem realen Teil der komplexen Leitfähigkeit des Plasmas ($\sigma$) abgeleitet wird, die beide von den Plasmaparametern abhängen.

**7.** Verfahren nach einem der Ansprüche 1 bis 6, wobei die gegenseitige Induktivität durch Bestimmen einer Resonanzfrequenz eines Resonanzkreises einschließlich der Messsonde bestimmt wird, wobei eine Sondentemperatur der Messsonde (2) bestimmt wird, wobei die bestimmte Resonanzfrequenz basierend auf der bestimmten Sondentemperatur korrigiert wird.

**8.** Verfahren nach einem der Ansprüche 1 bis 6, wobei die Temperatur der Messsonde (2) während der Messzeit konstant gehalten wird.

**9.** Messsonde (2) zum Bestimmen von Plasmaeigenschaften, umfassend:

- eine induktive Messsonde (2); und
- eine parallele oder serielle kapazitive Komponente, um einen Schwingkreis zu bilden;
- eine Vielzahl von Sondenzweigen, die jeweils eine Leitungsinduktivität in Reihe mit einem Zweigkondensator aufweisen, wobei die Vielzahl von Sondenzweigen mit Stringerkondensatoren eines Leiternetzes gekoppelt ist, wobei die Reihenresonanzfrequenz der Sondenzweige im Wesentlichen der von den Stringerkondensatoren bestimmten Parallelresonanzfrequenz entspricht.

**10.** Messsonde (2) nach Anspruch 9, umfassend eine Vielzahl von als Netzwerk angeordneten induktiven Elementen.

**11.** Messsonde (2) nach Anspruch 9 oder 10, die eine Anzahl von Kondensatoren beinhaltet.

**12.** Messsonde (2) nach einem der Ansprüche 9 bis 11, wobei die Kondensatoren einen Temperaturkoeffizienten ihrer Kapazität aufweisen, der ausreichend niedrig für die erforderliche Genauigkeit der Sondenmessung ist, oder wobei die Kondensatoren eine kontrollierte Temperatur aufweisen.

**13.** Messsystem (1), umfassend:

- eine Messsonde (2) zum Bestimmen von Plasmaeigenschaften, umfassend eine induktive Messsonde (2) und eine parallele oder serielle kapazitive Komponente zum Bilden eines Resonanzkreises; wobei die Messsonde (2) in der Nähe eines Plasmas (3) angeordnet ist, um eine induktive Kopplung herzustellen; und
- eine Steuereinheit zum Bestimmen von Plasmaeigenschaften, wobei die Steuereinheit konfiguriert ist, um eine gegenseitige Induktivität ($M_{probe/plasma}$) zwischen der Messsonde (2) und dem Plasma (3) zu bestimmen; um eine Größe zu schätzen, die die komplexe Leitfähigkeit des Plasmas ($\sigma$) in Abhängigkeit von der gegenseitigen Induktivität ($M_{probe/plasma}$) darstellt; und um mindestens einen Plasmaparameter aus der Größe abzuleiten, die die komplexe Leitfähigkeit des Plasmas ($\sigma$) darstellt.

**14.** Messsystem (1) nach Anspruch 13, wobei die Messsonde (2) mit einem Temperaturregelsystem gekoppelt ist, das konfiguriert ist, um die Temperatur der Messsonde (2) während der Messzeit konstant zu halten.

**Revendications**

**1.** Procédé de détermination de caractéristiques de plasma, comprenant les étapes consistant à :

- disposer une sonde de mesure (2) comportant une auto-inductance à proximité d'un plasma (3) pour établir un couplage inductif entre le plasma (3) et la sonde de mesure (2) ;
- déterminer une inductance mutuelle (Msonde/plasma) entre la sonde de mesure (2) et le plasma (3) ;
- estimer une quantité représentant la conductivité complexe du plasma ($\sigma$) en fonction de l'inductance mutuelle (Msonde/plasma) ; et
- dériver au moins un paramètre plasmique de la quantité représentant la conductivité du plasma ($\sigma$).

**2.** Procédé selon la revendication 1, dans lequel au moins l'un des paramètres plasmiques comprend une densité électronique ($n_e$) et une fréquence de collision neutre au niveau électronique ($v_m$).

**3.** Procédé selon la revendication 1 ou 2, dans lequel la quantité représentant la conductivité complexe du plasma ($\sigma$) correspond à la conductivité du complexe de plasma ($\sigma$), une résistivité complexe du plasma ou une distance complexe (p), dans lequel la distance complexe (p) est définie comme étant la distance d'un plan de symétrie d'une image symétrique de la sonde (2), dans lequel le plan de symétrie est situé à la distance complexe en dessous de la surface du plasma (PS), ce qui entraîne l'inductance mutuelle déterminée.

**4.** Procédé selon l'une quelconque des revendications 1 à 3, dans lequel l'inductance mutuelle ($M_{sonde/plasma}$) est déterminée par l'inductance mutuelle ($M_{sonde/plasma}$) entre la sonde de mesure (2) et son image par rapport à un plan de symétrie, dans lequel le plan de symétrie est situé à une distance complexe (p) en dessous de la surface du plasma (PS).

5. Procédé selon l'une quelconque des revendications 1 à 4, dans lequel l'inductance mutuelle est déterminée en déterminant un changement d'inductance de la sonde de mesure (2) avant et après que la sonde de mesure (2) a été disposée à proximité du plasma (3).

6. Procédé selon l'une quelconque des revendications 1 à 5, dans lequel la quantité représentant la conductivité complexe du plasma ($\sigma$) correspond à la conductivité complexe du plasma ($\sigma$), dans lequel au moins un paramètre plasmique est dérivé des parties imaginaire et réelle de la conductivité complexe du plasma ($\sigma$), qui dépendent toutes deux des paramètres plasmiques.

7. Procédé selon l'une quelconque des revendications 1 à 6, dans lequel l'inductance mutuelle est déterminée en déterminant une fréquence de résonance d'un circuit résonant comprenant la sonde de mesure, dans lequel une température de sonde de la sonde de mesure (2) est déterminée, dans lequel la fréquence de résonance déterminée est corrigée sur la base de la température de sonde déterminée.

8. Procédé selon l'une quelconque des revendications 1 à 6, dans lequel la température de la sonde de mesure (2) est maintenue constante pendant la mesure.

9. Sonde de mesure (2) destinée à déterminer des caractéristiques de plasma, comprenant :

   - une sonde de mesure inductive (2) ; et
   - un composant capacitif en parallèle ou en série destiné à former un circuit résonant ;
   - une pluralité de pattes de sonde comprenant chacune une inductance de ligne en série comportant un condensateur à patte, dans laquelle la pluralité de pattes de sonde sont couplées à des condensateurs de lisse d'un réseau en échelle, dans laquelle la fréquence de résonance en série des pattes de sonde correspond sensiblement à la fréquence de résonance en parallèle déterminée par les condensateurs de lisse.

10. Sonde de mesure (2) selon la revendication 9, comprenant une pluralité d'éléments inductifs disposés en réseau.

11. Sonde de mesure (2) selon la revendication 9 ou 10, comprenant un certain nombre de condensateurs.

12. Sonde de mesure (2) selon l'une quelconque des revendications 9 à 11, dans laquelle les condensateurs ont un coefficient de température de leur capacité suffisamment faible pour la précision requise par la mesure par sonde, ou dans laquelle les condensateurs ont une température régulée.

13. Système de mesure (1) comprenant :

   - une sonde de mesure (2) destinée à déterminer des caractéristiques de plasma, comprenant une sonde de mesure inductive (2) et un composant capacitif en parallèle ou en série destiné à former un circuit résonant ; dans lequel la sonde de mesure (2) est disposée à proximité d'un plasma (3) pour établir un couplage inductif ; et
   - une unité de commande destinée à déterminer des caractéristiques de plasma, dans lequel l'unité de commande est configurée pour déterminer une inductance mutuelle ($M_{sonde/plasma}$) entre la sonde de mesure (2) et le plasma (3) ; pour estimer une quantité représentant la conductivité complexe du plasma ($\sigma$) en fonction de l'inductance mutuelle ($M_{sonde/plasma}$) ; et pour déduire au moins un paramètre plasmique de la quantité représentant la conductivité complexe du plasma ($\sigma$).

14. Système de mesure (1) selon la revendication 13, dans lequel la sonde de mesure (2) est couplée à un système de commande de température configuré pour maintenir constante la température de la sonde de mesure (2) pendant la mesure.

**Fig. 1**

Start

Placing measurement probe — S1

Measuring probe impedance — S2

Determining mutual impedance — S3

Determining electrical conductivity of plasma — S4

Determining of plasma parameter — S5

**Fig. 2**

**Fig. 3**

**Fig. 4**

**Fig. 5**

**Fig. 6**

Fig. 7

Fig. 8

Fig. 9

Fig. 10

**EP 3 292 559 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5936413 A
- US 7061184 B2
- US 7878045 B2
- US 2005009347 A1
- US 2013160523 A1
- US 6573731 B1
- US 6861844 B1
- JP 2010232110 A
- US 2012084046 A1
- US 5471115 A
- US 4458202 A1
- US 5268646 A1
- WO 2010092433 A1